Europäisches Patentamt

European Patent Office

Office européen des brevets

(19)

(11) **EP 0 690 552 A2**

(12) **EUROPÄISCHE PATENTANMELDUNG**

(43) Veröffentlichungstag:
03.01.1996 Patentblatt 1996/01

(51) Int. Cl.⁶: **H02M 3/156**

(21) Anmeldenummer: 95108818.6

(22) Anmeldetag: 08.06.1995

(84) Benannte Vertragsstaaten:
**DE ES FR GB IT SE**

(30) Priorität: **02.07.1994 DE 4423325**

(71) Anmelder: **Moto Meter GmbH**
**D-71229 Leonberg (DE)**

(72) Erfinder:
• **Knoeri, Rudolf**
**D-75378 Bad Liebenzell (DE)**
• **Mroch, Siegfried, Dipl.-Ing.**
**D-71701 Schwieberdingen (DE)**

(74) Vertreter: **Friedmann, Jürgen, Dr.-Ing. et al**
**D-70442 Stuttgart (DE)**

(54) **Elektronischer Spannungswandler**

(57) Es wird ein elektronischer Spannungswandler vorgeschlagen, der dazu dient, eine pulsförmige Ausgangsspannung ($U_a$) zu erzeugen. Der elektronische Spannungswandler weist dazu ein Schaltmittel (1) auf, das den mit der Eingangsspannung ($U_B$) belegten Eingangsanschluß (84) mit einem Ausgangsanschluß (81), an dem die Ausgangsspannung ($U_a$) abgreifbar ist, verbindet, sowie einen Schwellwertschalter (4), der dann schaltet, wenn das Potential an einem Summationspunkt (82) eine Referenzspannung ($U_{ref}$) übersteigt. Dem Summationspunkt (82) ist zudem über ein Tiefpaßfilter (7) das Potential des Ausgangsanschlusses (81) zugeführt. Abhängig vom Ausgangssignal des Schwellwertschalters (4) wird das Schaltmittel (1) gesteuert sowie über ein Hochpaßfilter (6) eine Rückkopplung auf den Summationspunkt (82) bewirkt.

Fig. 1

**Beschreibung**

Stand der Technik

Die Erfindung geht aus von einem elektronischen Spannungswandler nach dem Oberbegriff des Hauptanspruchs. Es sind sogenannte Linear-Regler bekannt, die eine ungeregelte Eingangsspannung in eine geregelte, stabilisierte Ausgangsspannung umwandeln. Die stabilisierte Ausgangsspannung liegt dabei in ihrem Wert unterhalb der Eingangsspannung. Durch die Differenz der beiden Spannungen entsteht dabei eine hohe Verlustleistung, die im Linear-Regler in Wärme umgewandelt wird. Des weiteren ist ein abwärts wandelnder Schaltregler bekannt (MAX638 Adjustable CMOS Step-Down Switching Regulator), der eine unstabilisierte Gleichspannung in eine stabilisierte Gleichspannung umwandelt. Dabei weist der Schaltregler eine Induktivität auf, deren Stromspeicherfunktion ausgenutzt wird, um die Ausgangsspannung zu erhalten. Außerdem steht die Ausgangsspannung nur als stabilisierte Gleichspannung zur Verfügung.

Vorteile der Erfindung

Der erfindungsgemäße elektronische Spannungswandler mit den kennzeichnenden Merkmalen des Hauptanspruchs hat demgegenüber den Vorteil, daß keine Induktivität als Energiespeicher zur Erzeugung der Ausgangsspannung benötigt wird. Dadurch verringert sich der Herstellungspreis der Schaltung. Die EMV-Abstrahlung wird zusätzlich verringert und die EMV-Störfestigkeit gleichfalls verbessert. Außerdem sind Kondensatoren exakter herstellbar als Induktivitäten. Schließlich sind Induktivitäten im Gegensatz zu Kondensatoren nicht oder nur sehr schlecht integrierbar.

Hinzu kommt, daß für die in der erfindungsgemäßen Spannungswandler einzusetzenden Filter Bauteile mit höheren Toleranzen Anwendung finden können.

Als weiterer Vorteil tritt auf, daß die Schaltung besonders gut für eine Einflußnahme auf die Form der Eingangs-Ausgangs-Kennlinie durch weitere schaltungstechnische Mittel geeignet ist, da direkt an für den Regelvorgang wichtige Schaltungspunkte solche schaltungstechnischen Mittel eingefügt werden können. Somit ist die Schaltung nicht ausschließlich zur Erzeugung einer Ausgangsspannung mit konstantem Mittelwert konzipiert.

Durch die in den Unteransprüchen aufgeführten Maßnahmen sind vorteilhafte Weiterbildungen und Verbesserungen des im Hauptanspruch angegebenen Spannungswandlers möglich.

Die Addition eines Teils der Eingangsspannung auf den Summationspunkt bringt außerdem den Vorteil mit sich, daß bei steigender Eingangsspannung die Ausgangsspannung absinkt, so daß sich eine Approximation jener Leistungshyperbel ergibt, die für eine Ausgangsspannung charakteristisch ist, die einen konstanten Effektivwert aufweist. Somit kann mittels dieser schaltungstechnischen Maßnahme erreicht werden, daß eine Ausgangsspannung erzeugt wird, deren Effektivwert in erster Näherung konstant bleibt.

Eine noch genauere Annäherung an die für einen konstanten Effektivwert charakteristische Leistungshyperbel ergibt sich in vorteilhafter Weise dadurch, daß zwischen dem Eingangsanschluß und dem Bezugspotential eine Spannungsteilerschaltung mit einer Zener-Diode angeordnet ist, die zusammen die Referenzspannung in Form einer variablen Spannung bereitstellen, da dadurch eine teilweise Kompensation des durch die Aufschaltung über das Teilerglied erzeugten Effektes erreichbar ist. Da die Leistungshyperbel durch die Aufschaltung über das Teilerglied nur eine lineare Annäherung erfährt, kann durch die Bereitstellung der Referenzspannung über die Zener-Diode und den Spannungsteiler eine exaktere Annäherung erfolgen, indem die Auf- und Entladezeiten eines Ladekondensators verändert werden, wodurch die Nichtlinearität der Ladekurve des Ladekondensators in die Approximation so eingeht, daß die Leistungshyperbel genauer angenähert wird.

Wird das Potential am Summationspunkt auf den Spannungsbereich zwischen Massepotential und dem Potential der Eingangsspannung begrenzt, so entsteht der Vorteil, daß der Eingang des Schwellwertschalters vor unzulässig hohen oder niedrigen Spannungen geschützt ist. Die Begrenzung des Spannungsbereichs am Summationspunkt mittels zweier Dioden bietet den Vorteil, besonders preiswert zu sein. Außerdem wird diese Funktion somit durch einen sehr geringen Aufwand erfüllt.

Es gereicht zudem zu einem Vorteil, wenn das Hochpaßfilter und das Tiefpaßfilter durch nur eine Filterschaltung realisiert sind, deren Funktion variiert, da sich so eine Ersparnis an Schaltungsaufwand ergibt.

Eine besonders aufwandsarme Realisierung der Filterschaltung ist bereits durch die Kombination eines Ladekondensators und eines Widerstands gegeben, die in Serie zwischen Ausgangsanschluß und Schwellwertschalterausgang geschaltet sind und deren Mittelabgriff am Summationspunkt liegt.

Es erweist sich außerdem als vorteilhaft, einen Verpolschutz anzuordnen, damit der elektronische Spannungswandler vor Beschädigung durch versehentliches Verpolen zuverlässig geschützt ist.

Ebenso ergibt sich der Vorteil, daß der elektronische Spannungswandler zuverlässig vor EMV-Störstrahlungen geschützt ist, wenn entsprechende Kondensatoren vorgesehen sind, die eine Ableitung hochfrequenter Störstrahlungen bewirken.

Ein weiterer Vorteil ist dadurch gegeben, daß der Kollektor-Basis-Strecke des Transistors ein EMV-Schutzkondensator parallel geschaltet ist, da dadurch die Schaltflanken der Ausgangsspannung abgerundet werden, was zu einer geringeren EMV-Abstrahlung durch den Spannungswandler führt.

Die Beschaltung des elektronischen Spannungswandlers mit einer Leuchtdiode stellt ein besonders geeignetes Einsatzfeld für den elektronischen Spannungswandler dar, da durch die Approximation der Leistungshyperbel für eine Ausgangsspannung mit konstantem Effektivwert und die Tatsache, daß die Ausgangsspannung pulsförmig ist, für diese Leuchtdioden eine höhere Leuchtdichte erzielt werden kann, als mit herkömmlichen Spannungswandlern.

Zeichnung

Ausführungsbeispiele der Erfindung sind in der Zeichnung dargestellt und in der nachfolgenden Beschreibung näher erläutert.

Es zeigen:

Figur 1 ein Blockschaltbild des elektronischen Spannungswandlers,
Figur 2 ein Schaltbild für ein erstes Ausführungsbeispiel des elektronischen Spannungswandlers,
Figur 3 ein Schaltbild eines zweiten Ausführungsbeispiels des elektronischen Spannungswandlers,
Figur 4a eine Eingangs-/Ausgangskennlinie für einen Linear-Regler,
Figur 4b eine Eingangs-/Ausgangskennlinie mit einer Annäherung erster Ordnung an die Leistungshyperbel,
Figur 4c eine Eingangs-/Ausgangskennlinie mit einer Annäherung zweiter Ordnung an die Leistungshyperbel,
Figur 5a den Verlauf des Potentials am Summationspunkt mit Begrenzung der Komparatoreingangsspannung,
Figur 5b den Potentialverlauf am Schwellwertschalterausgang mit Begrenzung der Komparatoreingangsspannung,
Figur 5c den Potentialverlauf am Ausgangsanschluß mit Begrenzung der Komparatoreingangsspannung,
Figur 6 eine schematische Darstellung der Abhängigkeit der Ausgangsspannung von der Eingangsspannung in einem Diagramm.
Figur 7a den Verlauf des Potentials am Summationspunkt ohne Begrenzung der Komparatoreingangsspannung,
Figur 7b den Potentialverlauf am Schwellwertschalterausgang ohne Begrenzung der Komparatoreingangsspannung,
Figur 7c den Potentialverlauf am Ausgangsanschluß ohne Begrenzung der Komparatoreingangsspannung,

Beschreibung der Ausführungsbeispiele

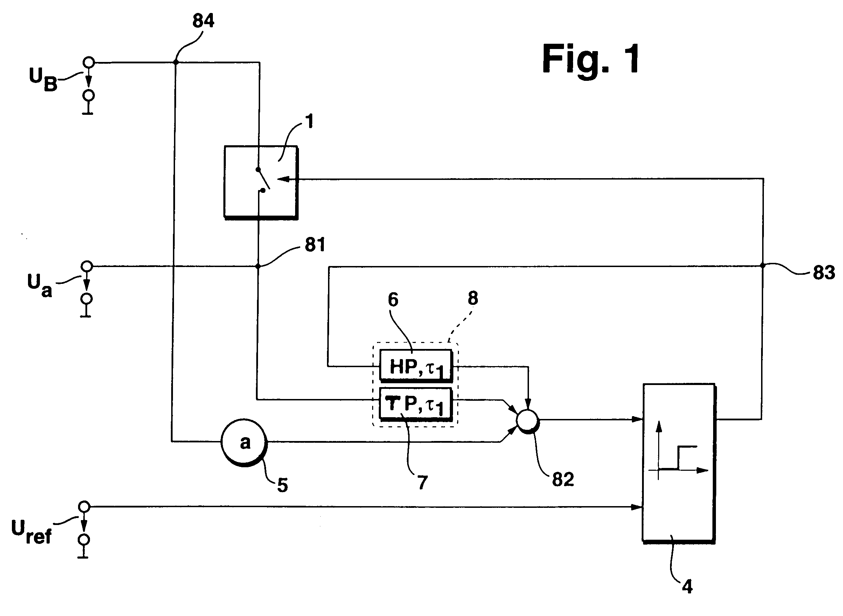

In Figur 1 ist ein Blockschaltbild für einen elektronischen Spannungswandler dargestellt. An einem Eingangsanschluß 84 liegt eine Eingangsspannung $U_B$. Der Eingangsanschluß 84 ist mit einem elektronisch steuerbaren Schaltmittel 1 verbunden. Der Ausgang des Schaltmittels 1 ist mit einem Ausgangsanschluß 81 verbunden, an dem eine Ausgangsspannung $U_a$ abgreifbar ist. Der Ausgangsanschluß 81 ist über ein Tiefpaßfilter 7 mit einer Zeitkonstante $\tau_1$ mit einem Summationspunkt 82 verbunden. Der Summationspunkt 82 ist einem Eingang eines Schwellwertschalters 4 vorgeschaltet. Außerdem ist dem Schwellwertschalter 4 eine Referenzspannung $U_{ref}$ zugeführt. Der Schwellwertschalter 4 weist einen Schwellwertschalterausgang 83 auf, der über ein Hochpaßfilter 6, welches die gleiche Zeitkonstante $\tau_1$ aufweist, wie das Tiefpaßfilter 6, mit dem Summationspunkt 82 und außerdem direkt mit einem Steuereingang des Schaltmittels 1 verbunden ist. Das Hochpaßfilter 6 und das Tiefpaßfilter 7 sind zu einer Filterschaltung 8 zusammengefaßt. Zusätzlich ist der Eingangsanschluß 84 über einen Spannungsteiler 5 mit einem Teilerfaktor a mit dem Summationspunkt 82 verbunden. Alle Spannungen sind auf ein Bezugspotential bezogen, welches das Massepotential ist.

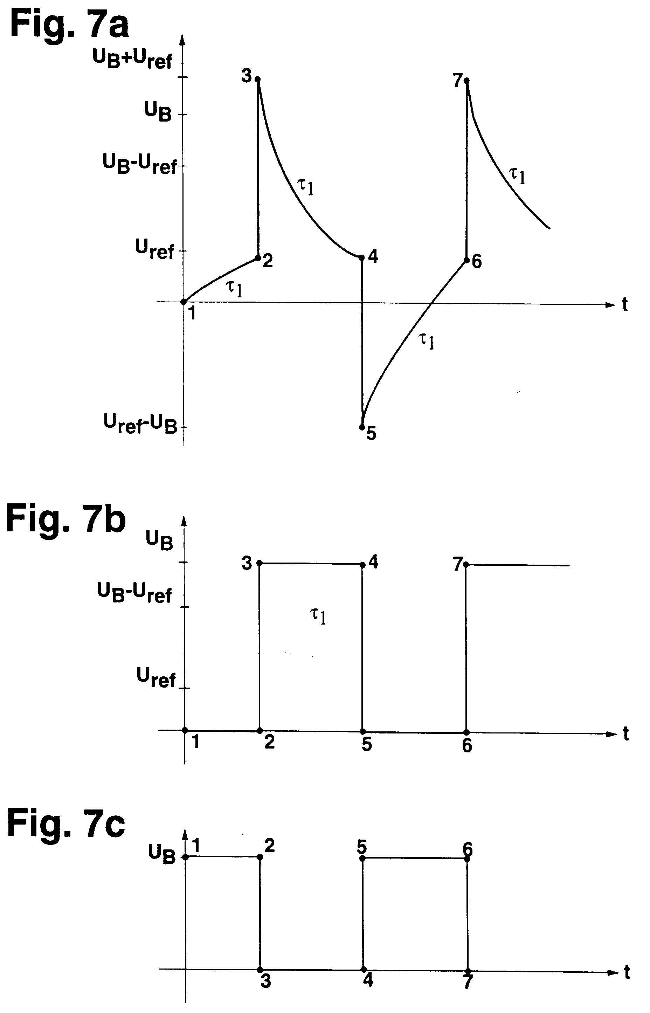

Zur Beschreibung der Funktionsweise der oben beschriebenen Schaltung wird auf die Figuren 7a, b, c Bezug genommen. Es sei von folgender Situation ausgegangen: Der Schwellwertschalter 4 ist als Gegentaktverstärker ausgebildet, so daß je nach Schaltzustand entweder das Massepotential oder das Betriebspotential des Schwellwertschalters 4 am Schwellwertschalterausgang 83 anliegt. Als Betriebspotential für den Schwellwertschalter 4 dient das Potential der Eingangsspannung $U_B$. Das Potential des Summationspunktes 82 befindet sich zunächst auf einem Potential von 0 Volt. Das Potential des Schwellwertschalterausgangs 83 und das Potential am Ausgangsanschluß 81 befinden sich ebenfalls auf einem Potential von 0 Volt. Das Schaltmittel 1 ist in einem offenen Zustand, d.h. der Eingangsanschluß 84 ist mit dem Ausgangsanschluß 81 nicht verbunden. Die Referenzspannung $U_{ref}$ ist höher als das Massepotential und niedriger als die Eingangsspannung $U_B$. Der Ausgangsanschluß 81 ist mit einer niederohmigen Last beschaltet. Diese Situation ist in den Figuren 7a, b, c mit der Ziffer 1 markiert.

Das Schaltmittel 1 wird nun geschlossen, d.h. der Eingangsanschluß 84 mit dem Ausgangsanschluß 81 leitend verbunden. Da das elektronisch steuerbare Schaltmittel 1 gerade geschlossen wurde, springt das Potential am Ausgangsanschluß 81 auf das Potential am Eingangsanschluß 84, also auf das Potential der Eingangsspannung $U_B$. Dieser Spannungssprung wird über das Tiefpaßfilter 7 mit der Zeitkonstante $\tau_1$ auf den Summationspunkt 82 übertragen. Dadurch folgt das Potential am Summationspunkt 82 diesem Sprung am Ausgangsanschluß 81 mit einer Zeitverzögerung, welche durch die Zeitkonstante $\tau_1$ bestimmt wird, von 0 Volt ausgehend bis zum Wert der Referenzspannung $U_{ref}$. Diese Situation ist in den Figuren 7a, b, c mit der Ziffer 2 markiert.

Sobald das Potential am Summationspunkt 82 das Potential der Referenzspannung $U_{ref}$ erreicht hat, schaltet der Schwellwertschalter 4 das Potential an seinem Schwellwertschalterausgang 83 von 0 Volt auf das Potential der Eingangsspannung $U_B$. Dieser Sprung gelangt verzögert über das Hochpaßfilter 6 mit der Zeitkonstante $\tau_1$ vom Schwellwertschalterausgang 83 zurück zum Summationspunkt 82. Das Potential am Summationspunkt 82 folgt wiederum zunächst diesem Sprung, so daß am Summationspunkt 82 daraufhin das Potential $U_B+U_{ref}$ anliegt. Diese Situation ist in den Figuren 7a, b, c mit der Ziffer 3 markiert.

In diesem Moment wird außerdem durch den Potentialsprung am Schwellwertschalterausgang 83 ein Öffnen des Schaltmittels 1 bewirkt. Durch das Öffnen des Schaltmittels 1 wird der Ausgangsanschluß 81 elektrisch vom Eingangsanschluß 84 getrennt. Da der Ausgangsanschluß 81 niederohmig belastet ist, bricht die dort anliegende Ausgangsspannung $U_a$ sehr schnell auf 0 Volt zusammen. Dieser negative Spannungssprung am Ausgangsanschluß 81 wird ebenfalls wieder über das Tiefpaßfilter 7 mit der Zeitkonstante $\tau_1$ verzögert zum Summationspunkt 82 geleitet. Das Potential am Summationspunkt 82 sinkt dadurch vom Potential $U_B+U_{ref}$ in Richtung zum Massepotential ab bis zum Potential der Referenzspannung $U_{ref}$. Diese Situation ist in den Figuren 7a, b, c mit der Ziffer 4 markiert.

In dem Moment, in dem das Potential am Summationspunkt 82 die Referenzspannung $U_{ref}$ erreicht hat, schaltet der Schwellwertschalter 4 das Potential an seinem Schwellwertschalterausgang 83 wieder auf das Massepotential. Dieser Spannungssprung wird über das Hochpaßfilter 6 mit der Zeitkonstante $\tau_1$ verzögert an den Summationspunkt 82 übertragen. Das Potential am Summationspunkt 82 sinkt daraufhin dem Spannungssprung folgend bis zum Potential $U_{ref}-U_B$ ab. Diese Situation ist in den Figuren 7a, b, c mit der Ziffer 5 markiert.

Durch das Absinken des Potentials am Schwellwertschalterausgang 83 wird das Schaltmittel 1 wieder geschlossen.

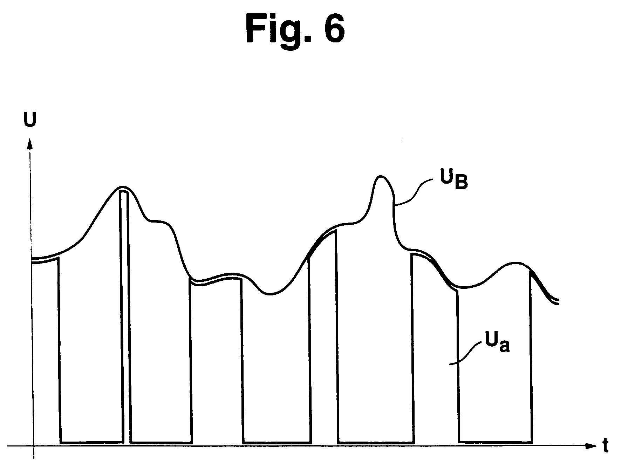

Somit ist ein kompletter Schaltzyklus des elektronischen Spannungswandlers durchlaufen. Die Periode eines Schaltzyklus verläuft im eingeschwungenen Zustand, wie in den Figuren 7a, b, c erkennbar, von Ziffer 2 bis Ziffer 6. Die am Ausgangsanschluß 81 entstehende Ausgangsspannung $U_a$ stellt eine gepulste Spannung dar, welche als Amplitude nahezu den Wert der Eingangsspannung $U_B$ aufweist. In den Schaltpausen besitzt die Ausgangsspannung $U_a$ das Massepotential, wodurch in dieser Schaltpause kein Strom am Ausgangsanschluß 81 entnommen werden kann. Ein Beispielsverlauf für die Eingangsspannung $U_B$ und die Ausgangsspannung $U_a$ ist in Figur 6 dargestellt. Durch die gepulste Form der Ausgangsspannung $U_a$ wird im Bereich der Pulslücken somit auch keine Verlustleistung in Wärme umgesetzt, weil die Ausgangsspannung $U_a$ gleich 0 Volt ist. Im Bereich der Pulse wird nur eine sehr geringe Verlustleistung in Wärme umgesetzt, weil die Differenz zwischen der Eingangsspannung $U_B$ und der Ausgangsspannung $U_a$ nur sehr gering ist. Die so beschriebene Schaltung ist so aufgebaut, daß bei einer Variation der Eingangsspannung $U_B$ eine Variation des Puls/Pausen-Verhältnisses der Ausgangsspannung $U_a$ resultiert, dergestalt, daß sich ein annähernd konstanter Mittelwert der Ausgangsspannung $U_a$ einstellt.

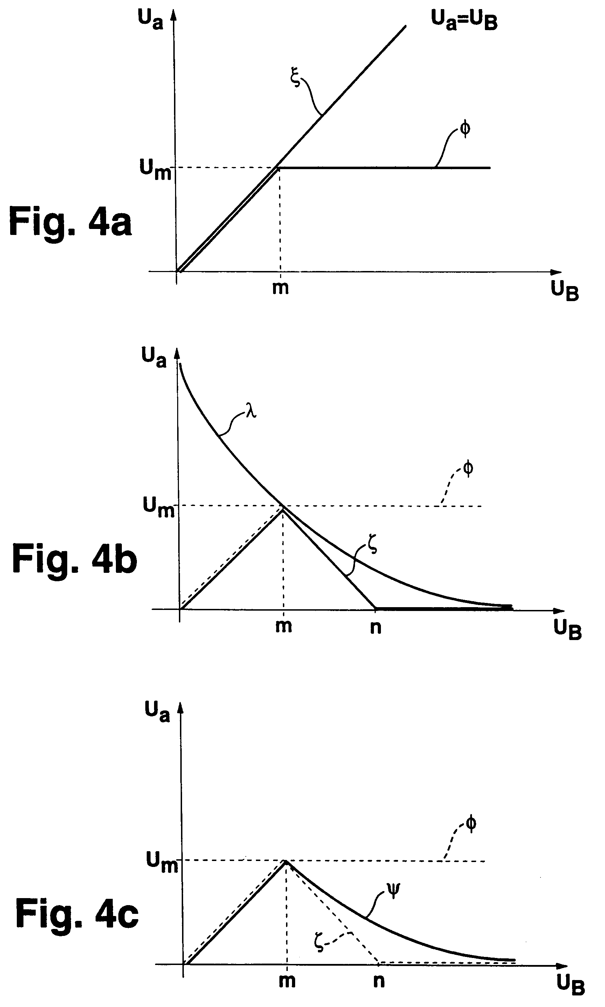

Es ist nun ein weiteres Ziel der Erfindung, den elektronischen Spannungswandler so zu gestalten, daß eine Ausgangsspannung $U_a$ abgreifbar ist, deren Effektivwert möglichst konstant bleibt. Dies soll anhand der Figuren 4a, b, c näher erläutert werden.

Im Diagramm der Figur 4a ist eine Linie $\xi$ eingezeichnet, die dem Fall entspricht, wenn die Mittelwerte der Eingangsspannung $U_B$ und der Ausgangsspannung $U_a$ gleich groß sind. Außerdem ist eine weitere Linie $\phi$ eingezeichnet. Bis zum Knickpunkt m folgt die Linie $\phi$ der Linie $\xi$, um dann bei einem konstanten Mittelwert $U_m$ zu bleiben. Dies stellt die Grundfunktion der Schaltung dar, nämlich eine Bereitstellung der gepulsten Ausgangsspannung $U_a$ mit annähernd konstantem arithmetischem Mittelwert.

Da die Ausgangsspannung $U_a$ als gepulste Spannung erzeugt wird, deren Amplitude bei geschlossenem Schaltmittel 1 immer nahezu gleich der Amplitude der Eingangsspannung $U_B$ ist, muß für einen gleichbleibenden Effektivwert der Ausgangsspannung $U_a$ bei steigender Amplitude der Eingangsspannung $U_B$ das Puls/Pausen-Verhältnis, d.h. die Breite des Pulses bezogen auf die Pausendauer bis zur steigenden Flanke des nächsten Pulses, stärker als für die Erhaltung eines konstanten Mittelwerts verringert werden.

In Figur 4b ist zusätzlich eine Linie $\zeta$ eingezeichnet, die ab dem Knickpunkt m wieder abfällt, um ab einem Basispunkt n wieder horizontal zu verlaufen. Es wurde zur Vereinfachung eine ungefähre Darstellung des Verlaufes der Linie $\zeta$ gewählt. Der tatsächliche Verlauf der Linie $\zeta$ weicht insbesondere aufgrund der Nichtlinearität der Ladekurve eines im Hochpaßfilter 6 bzw. Tiefpaßfilter 7 enthaltenen Ladekondensators etwas vom hier dargestellten Verlauf ab. Der gezeigte Kurvenverlauf der Linie $\zeta$ wird durch das Aufschalten der Eingangsspannung $U_B$ auf den Summationspunkt 82 über den Spannungsteiler 5 erreicht. Durch die Aufschaltung des mittels des Spannungsteilers 5 geteilten Potentials am Eingangsanschluß 84 auf den Summationspunkt 82 wird erreicht, daß nicht nur die Ausgangsspannung $U_a$ in ihrer Spannungs-Zeit-Fläche geregelt wird, sondern daß die Summe aus der Ausgangsspannung $U_a$ und der geteilten Eingangsspannung $U_B$ in ihrer Spannungs-Zeit-Fläche geregelt wird, so daß ein Ansteigen der Eingangsspannung $U_B$ eine entsprechende Verringerung der Ausgangsspannung $U_a$ bewirkt. Dadurch wird also eine gegenläufige Abhängigkeit der Ausgangsspannung $U_a$ von der Eingangsspannung $U_B$ erreicht.

Die für einen konstanten Effektivwert verlaufende Mittelwertlinie ist als Linie $\lambda$ eingezeichnet, die die Form einer Hyperbel hat, also eine negative quadratische Abhängigkeit (Exponent -2) aufweist. Wegen der Relevanz des Effektivwerts für die in Wärme umgesetzte Leistung wird diese Linie $\lambda$ auch Leistungshyperbel $\lambda$ genannt.

Wie anhand der Linie $\zeta$ in der Figur 4b zu erkennen ist, steigt somit der Mittelwert der Ausgangsspannung $U_a$ zunächst linear mit der Eingangsspannung $U_B$ an, um ab dem Knickpunkt m wieder linear abzusinken. Dies entspricht einer ersten Annäherung an die Leistungshyperbel $\lambda$, die für einen konstanten Effektivwert (negative quadratische Abhängigkeit) ideal wäre. Ab dem Basispunkt n verläuft der Mittelwert wieder horizontal, da eine Begrenzung der Ausgangsspannung $U_a$ auf das Massepotential stattfindet. Die Schaltung sollte nicht in diesem Bereich betrieben werden, da dort keine sinnvoll verwertbare Ausgangsspannung $U_a$ mehr vorliegt.

In Figur 4c ist eine Linie $\psi$ eingezeichnet, die dem Verlauf des Mittelwerts der Ausgangsspannung $U_a$ bei einer zusätzlichen schaltungstechnischen Maßnahme entspricht. Dieser Verlauf wird dadurch erreicht, daß die Referenzspannung $U_{ref}$ als Teil der Eingangsspannung $U_B$ an den Schwellwertschalter 4 geführt wird. Dadurch ergibt sich eine teilweise Aufhebung des durch die Aufschaltung mittels des Spannungsteilers 5 erzeugten Effekts, der durch seinen annähernd linearen Verlauf, wie an der Linie $\zeta$ vor dem Basispunkt n in Figur 4b zu erkennen ist, einen zu niedrigen Mittelwert ergibt. Dabei ist das Ausmaß der Kompensation als Funktion des gewählten Teilerfaktors für die Ableitung der Referenzspannung $U_{ref}$ von der Eingangsspannung $U_B$ wählbar. Durch die variable Referenzspannung $U_{ref}$ wird der Schaltpunkt des Schwellwertschalters 4 in Abhängigkeit von der Eingangsspannung $U_B$ verschoben. Dadurch variieren die Auf- und Entladezeiten des Ladekondensators, wodurch die Nichtlinearität der Ladekurve des Ladekondensators so in die Approximation eingeht, daß eine exaktere Annäherung der Linie $\psi$ an die Leistungshyperbel $\lambda$ resultiert.

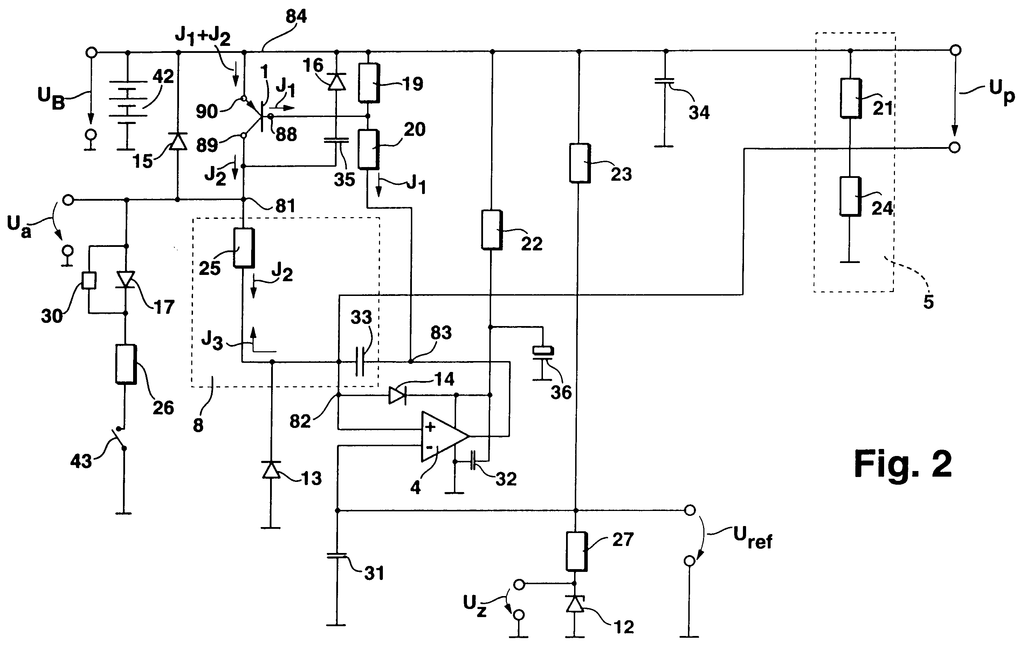

In Figur 2 ist ein Schaltbild einer ersten Ausführungsform des elektronischen Spannungswandlers dargestellt. Die Numerierungen und Bezeichnungen aus der Figur 1 wurden dabei beibehalten. Als Bezugspotential dient hier wiederum das Massepotential. Der Eingangsanschluß 84 ist als Eingangsklemme ausgebildet. Ebenso ist der Ausgangsanschluß 82 als Ausgangsklemme ausgebildet. Das Schaltmittel 1 ist in Form eines Transistors realisiert. Der Spannungsteiler 5 umfaßt zwei Widerstände 21, 24, die zwischen dem Eingangsanschluß 84 und dem Massepotential in Serie geschaltet sind. Der Schwellwertschalter 4 ist in Form eines Komparators mit Open-Kollektor-Ausgang ausgeführt. An der Eingangsklemme 84 wird die Eingangsspannung $U_B$ mittels einer Batterie 42 erzeugt. Weiter ist zwischen der Eingangsklemme 84 und der Ausgangsklemme 81 der Transistor 1 angeordnet, wobei dessen Emitter 90 mit der Eingangsklemme 84, dessen Kollektor 89 mit der Ausgangsklemme 81 und dessen Basis 88 über einen ersten Widerstand 19 mit der Eingangsklemme 84 verbunden ist. Parallel zum ersten Widerstand 19 ist eine erste Diode 16 geschaltet, deren Anode an der Basis 88 des Transistors 1 liegt. Zwischen der Basis 88 des Transistors 1 und der Ausgangsklemme 81 ist ein EMV-Schutzkondensator 35 angeordnet. Aus der Basis 88 fließt ein Basisstrom $I_1$ und aus dem Kollektor 89 ein Kollektorstrom $I_2$. Weiter ist die Ausgangsklemme 81 über eine zweite Diode 15 mit der Eingangsklemme 84 verbunden, wobei die Anode der Diode 15 mit der Ausgangsklemme 81 verbunden ist. Von der Ausgangsklemme 81 führt ein zweiter Widerstand 25 zu einem Summationspunkt 82, der über eine Parallelschaltung eines dritten Widerstands 24 und einer dritten Diode 13, deren Anode auf Massepotential liegt, mit dem Massepotential verbunden ist. Der Summationspunkt 82 ist außerdem mit einem Ladekondensator 33 sowie mit dem nichtinvertierenden Eingang des Komparators 4 verbunden. Der weitere Anschluß des Ladekondensators 33 ist mit dem Komparatorausgang 83 des Komparators 4 verbunden. Der Komparatorausgang 83 ist über einen vierten Widerstand 20 mit der Basis 88 des Transistors 1 verbunden. Zwischen dem Summationspunkt 82 und der Eingangsklemme 84 ist der fünfte Widerstand 21 angeordnet, an dem eine Hilfsspannung $U_p$ abfällt. Der zweite Widerstand 25 und der Ladekondensator 33 bilden zusammen die Filterschaltung 8. Der invertierende Eingang des Komparators 4 ist über einen ersten Schutzkondensator 31 sowie über eine Serienschaltung aus einem sechsten Widerstand 27 und einer Zener-Diode 12, deren Anode auf Massepotential liegt und an der eine Zener-Spannung $U_z$ abgreifbar ist, mit dem Massepotential verbunden. Außerdem ist der invertierende Eingang des Komparators 4 über einen siebten Widerstand 23 mit der Eingangsklemme 84 verbunden, wodurch parallel zum ersten Schutzkondensator 31 die Referenzspannung $U_{ref}$ abgreifbar ist. Die Eingangsklemme 84 ist über einen zweiten Schutzkondensator 34 mit dem Massepotential verbunden. Die Spannungsversorgung des Komparators 4 erfolgt über eine Verbindung seines negativen Spannungsversorgungsanschlusses mit dem Massepotential und eine Verbindung seines positiven Spannungsversorgungsanschlusses über einen achten Widerstand 22 mit der Eingangsklemme 84. Der positive Spannungsversorgungsanschluß des Komparators 4 ist außerdem über eine vierte Diode 14 mit dem nichtinvertierenden Eingang des Komparators 4 verbunden, wobei die Anode der vierten Diode 14 mit dem Summationspunkt 82 verbunden ist. Der positive und der negative Spannungsversorgungsanschluß des Komparators 4 sind über einen dritten Schutzkondensator 32 miteinander verbunden. An der Ausgangsklemme 81 ist die Ausgangsspannung $U_a$ abgreifbar und als Last eine Leuchtdiode 17 in Serie mit einem neunten Widerstand 26 und einem Schalter 43 zum Massepotential geschaltet, wobei die Anode der Leuchtdiode 17 an der Ausgangsklemme 81 liegt. Der Leuchtdiode 30 ist ein niederohmiger elfter Widerstand 30 parallelgeschaltet. An der Kathode der vierten Diode 14 ist noch ein Elektrolytkondensator 36 angeschlossen, dessen weiterer Anschluß am Massepotential liegt.

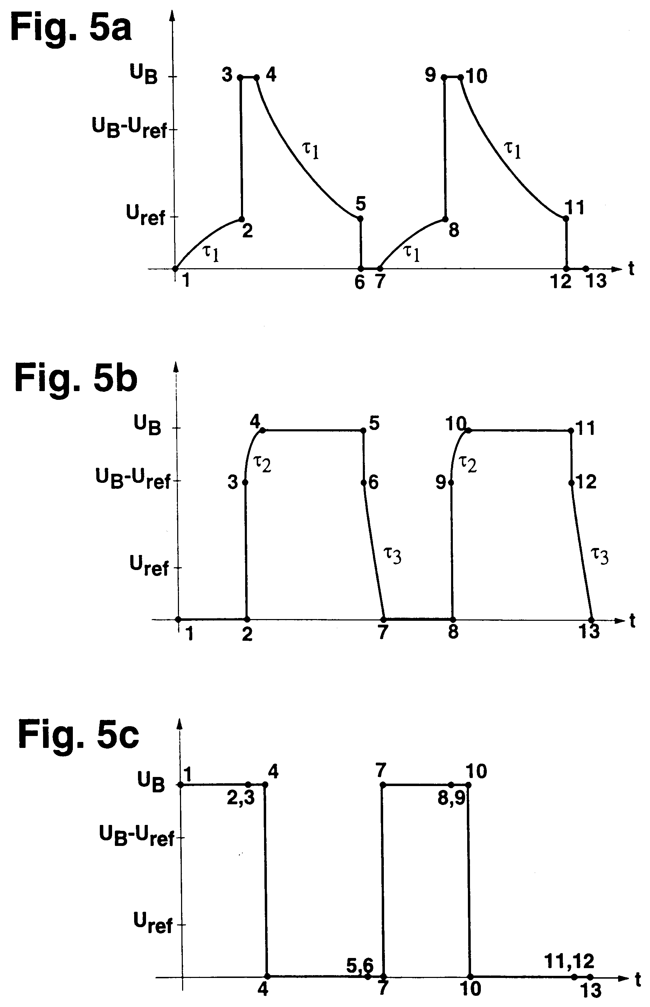

Es wird zur Erklärung nun auf die Figuren 5a, b, c Bezug genommen. Der Verlauf der dort gezeigten Kurven ist prinzipiell gleich dem der Kurven aus den Figuren 7a, b, c, bis auf die Tatsache, daß der Spannungsbereich der Spannung am Summationspunkt 82 auf den Bereich zwischen der Versorgungsspannung des Komparators 4, die beispielhaft die Eingangsspannung $U_B$ ist, und dem Massepotential begrenzt ist. Daraus resultieren auch Änderungen bezüglich der Zeitkonstanten, worauf im folgenden noch eingegangen werden wird.

Als Ausgangssituation für die Beschreibung der Funktionsweise der oben beschriebenen Schaltung sei folgender Ausgangszustand angenommen: Die Potentiale an der Ausgangsklemme 81 und am Komparatorausgang 83 befinden sich auf dem Potential 0 Volt, d.h. Massepotential. Das Potential am Summationspunkt 82 befindet sich gleichfalls auf Massepotential. Die Referenzspannung $U_{ref}$ ist höher als das Massepotential. Der Ladekondensator 33 ist entladen. Der Transistor 1 leitet. Der Schalter 43 ist geschlossen und der neunte Widerstand 26 ist niederohmig. Diese Situation ist in den Figuren 5a, b, c mit der Ziffer 1 markiert.

Es fließt bei leitendem Transistor 7 der Basisstrom $I_1$ über den Emitter 90 zur Basis 88 von dort über den vierten Widerstand 20 zum Schwellwertschalterausgang 83. Der Kollektorstrom $I_2$ fließt von der Eingangsklemme 84 über den Emitter 90 und den Kollektor 89 zur Ausgangsklemme 81 und von dort über den zweiten Widerstand 25 zum Summationspunkt 82 und über den dritten Widerstand 24 zum Massepotential. Durch den eingeschalteten Transistor 1 liegt das Potential an der Ausgangsklemme 81 nahezu auf dem Potential der Eingangsspannung $U_B$. Die Ausgangsspannung $U_a$ folgt in ihrem Verlauf dabei der Eingangsspannung $U_B$. Der Ladekondensator 33 wird über den über den zweiten Widerstand 25 fließenden Anteil des Kollektorstroms $I_2$ aufgeladen. Der Komparator 4 legt das Potential des Schwellwertschalterausgangs 83 aufgrund der am invertierenden und am nichtinvertierenden Eingang vorliegenden Potentiale auf 0 Volt fest. Am Summationspunkt 82 baut sich ein Potential auf, das ausgehend vom Potential 0 Volt mit der Zeitkonstante (zweiter Widerstand 25||dritter Widerstand 24) * Ladekondensator $33 = t_1$ anwächst, während der Ladekondensator 33 aufgeladen wird. (zweiter Widerstand 25||dritter Widerstand 24) ist dabei der Innenwiderstand des Spannungsteilers 5 mit dem zweiten Widerstand 25. Die Filterschaltung 8 fungiert hier als Tiefpaßfilter. In dem Moment, in dem sich der Summationspunkt 82 auf dem Potential $U = U_{ref}$ befindet schaltet der Komparator 4 seinen Komparatorausgang 83 in einen hochohmigen Zustand. Diese Situation ist in den Figuren 5a, b, c mit der Ziffer 2 markiert.

Durch diese Umschaltung verringert sich plötzlich der Basisstrom $I_1$, so daß das Potential am Komparatorausgang 83 über den ersten Widerstand 19 und den vierten Widerstand 20 in Richtung zum Potential an der Eingangsklemme 84 gezogen wird. An Kondensatoren können bekanntlich keine abrupten Spannungssprünge an nur einem Anschluß erfolgen. Dieser Spannungssprung pflanzt sich deshalb über den Ladekondensator 33 zum Summationspunkt 82 fort, dessen Potential um den gleichen Betrag springt, wie das Potential des Schwellwertschalterausgangs 83. Da die vierte Diode 14 das Potential des Summationspunkts 82 auf das Potential der Eingangsspannung $U_B$ begrenzt, findet am Summationspunkt 82 nur ein Sprung bis zum Potential der Eingangsspannung $U_B$ statt. Die Filterschaltung 8 fungiert hierbei also als Hochpaßfilter. Dadurch springt auch das Potential am Komparatorausgang 83 ausgehend von 0 Volt nur bis zum Potential $U_B - U_{ref}$. Diese Situation ist in den Figuren 5a, b, c mit der Ziffer 3 markiert.

Der Basisstrom $I_1$ über die Emitter-Basis-Strecke des Transistors 1 entlädt daraufhin den Ladekondensator 33 mit einer Zeitkonstante (vierter Widerstand 20 * Ladekondensator 33) $= t_2$, bis am Komparatorausgang 83 das Potential der Eingangsspannung $U_B$ anliegt. Dann sperrt der Transistor 1, d.h. er unterbricht die Verbindung zwischen Emitter 90 und Kollektor 89. Der erste Widerstand 19 dient dabei der Ausräumung der Ladungsträger aus der Basis 88, damit ein zeitlich korrektes Abschalten des Transistors 1 erfolgt. Durch die niederohmige Belastung der Ausgangsklemme 81 über den niederohmigen elften Widerstand 30 bricht die Spannung an der Ausgangsklemme 81 relativ schnell zusammen, bis das Potential an der Ausgangsklemme 81 auf dem Massepotential liegt. Diese Situation ist in den Figuren 5a, b, c mit der Ziffer 4 markiert.

Dabei beginnt ein Ladestrom $I_3$, über den Ladekondensator 33 und den zweiten Widerstand 25 sowie den dritten Widerstand 24 zur Ausgangsklemme 81 zu fließen. Der Komparatorausgang 83 befindet sich immer noch auf dem Potential der Eingangsspannung $U_B$, und der Ladekondensator 33 wird über den Ladestrom $I_3$ aufgeladen, bis das Potential am Summationspunkt 82 auf das Potential der Referenzspannung $U_{ref}$ abgesunken ist. Dieses Aufladen verläuft ebenfalls mit der Zeitkonstante (zweiter Widerstand 25||dritter Widerstand 24) * Ladekondensator $33 = t_1$. Die Filterschaltung 8 fungiert hierbei also als Tiefpaßfilter. Diese Situation ist in den Figuren 5a, b, c mit der Ziffer 5 markiert.

In dem Moment, wenn das Potential am Summationspunkt 82 das Potential der Referenzspannung $U_{ref}$ unterschreitet, schaltet der Komparator 4 seinen Komparatorausgang 83 auf Massepotential. Dieser Potentialsprung wird wiederum über den Ladekondensator 33 auf den Summationspunkt 82 übertragen, dessen Potential um denselben Spannungsbetrag in Richtung Massepotential springt, wie das Potential des Komparatorausgangs 83. Die Begrenzung dieses Sprunges durch die dritte Diode 13 bewirkt jedoch, daß das Potential am Summationspunkt 82 nur bis zum Massepotential springt. Damit wird auch der Sprung des Potentials am Komparatorausgang 83 auf den Wert $U_B - U_{ref}$ begrenzt. Diese Situation ist in den Figuren 5a, b, c mit der Ziffer 6 markiert.

Es folgt ein Entladestrom mit einer relativ geringen Zeitkonstante $\tau_3$, vom Komparatorausgang 83 des Komparators 4 über den Ladekondensator 33 und die leitende dritte Diode 13 bis auch am Komparatorausgang 83 Massepotential anliegt. Diese Situation ist in den Figuren 5a, b, c mit der Ziffer 7 markiert.

Die dritte Diode 13 schützt dabei vor allem den nichtinvertierenden Eingang des Komparators 4 vor negativen Potentialen. Die Veränderung des Potentials am Komparatorausgang 83 bewirkt ein erneutes Durchschalten des Transistors 1. Damit liegt wieder die Situation wie am Anfang des Schaltungszyklus vor, nämlich Massepotential am Komparatorausgang 83 und am Summationspunkt 82, sowie das Potential der Eingangsspannung $U_B$ an der Ausgangsklemme 81 und der Eingangsklemme 84. Der Ladekondensator 33 ist entladen und der Transistor 1 leitet. Der zweite Widerstand 25, der dritte Widerstand 24 und der Ladekondensator 33 bestimmen also im wesentlichen die Zeitkonstante $\tau_1$, die je nach Zustand der Schaltung ein Hochpaß- oder Tiefpaßverhalten der Filterschaltung 8 erzeugt.

Auch bei dieser Schaltung ist ein effektivwertgetreues Verhalten erzeugbar. Wieder werden die Effekte der in den Figuren 4a, b, c gezeigten Abhängigkeiten durch schaltungstechnische Weiterbildungen erzeugt. Die bisher beschriebenen Schaltungsteile erzeugen eine Abhängigkeit des Mittelwerts der Ausgangsspannung $U_a$ vom Mittelwert der Eingangsspannung $U_B$ in Form der Linie $\phi$ in Figur 4a. Durch die Aufschaltung eines Anteils der Hilfsspannung $U_p$ über den fünften Widerstand 21 erfolgt eine Regelung der Summe aus dem aufgeschalteten Anteil und dem über den Spannungsteiler aus dem zweiten Widerstand 25 und dem dritten Widerstand 24 festgelegten Anteil der Ausgangsspannung $U_a$ mittels des Komparators 4. Daraus resultiert bei steigender Eingangsspannung $U_B$ somit ein Absinken der Ausgangsspannung $U_a$. Dies bewirkt den linearen Abfall der Linie $\zeta$ in Figur 4b. Als zusätzlicher Effekt entsteht durch die Aufschaltung über den fünften Widerstand 21 ein Schutzeffekt, da bei einem Ansteigen der Eingangsspannung $U_B$ über einen Grenzwert, der durch den Spannungsteiler 5 aus dem fünften Widerstand 21 und dem dritten Widerstand 24 festgelegt ist, der Komparator 4 seinen Komparatorausgang 83 dauerhaft auf den hochohmigen Zustand schaltet, wodurch kurz darauf mittels des Transistors 1 ein dauerhaftes Trennen der Ausgangsklemme 81 von der Eingangsklemme 84 erfolgt und so die Ausgangsklemme 81 vor zu hohem Potential geschützt ist.

Zusätzlich wird über die Verbindung des siebten Widerstandes 23 mit dem sechsten Widerstand 27 und der Zener-Diode 12 eine Ankopplung der Referenzspannung $U_{ref}$ an die Eingangsspannung $U_B$ erreicht. Die Nachführung der Referenzspannung $U_{ref}$, die dadurch erreicht wird, bewirkt ein entsprechendes Ansteigen der Ausgangsspannung $U_a$ mit dem Faktor, der durch das Teilerverhältnis der Widerstände 23, 27 sowie mit einem Offset, der durch die Zener-Spannung $U_z$ eingestellt ist. Die entsprechende Abhängigkeit der Ausgangsspannung $U_a$ von der Eingangsspannung $U_B$ ist in der Linie $\psi$ der Figur 4c dargestellt.

Der EMV-Schutzkondensator 35 dient der Abrundung der Schaltflanken des Transistors 1, wodurch das Frequenzspektrum der Ausgangsspannung $U_a$ verringert wird, was zu einer geringeren Abstrahlung von hohen Frequenzen führt und damit dem EMV-Schutz anderer Schaltungen dient.

Die Kondensatoren 32, 31, 36 und 34 dienen als EMV-Schutzmaßnahme, in dem sie hochfrequente Störstrahlungen zum Massepotential hin ableiten. Der zweite Schutzkondensator 34 dient dabei ebenso wie der dritte Schutzkondensator 32 vorrangig dem Schutz vor kürzeren Störimpulsen. Der Elektrolytkondensator 36 stellt in Verbindung mit dem achten Widerstand 22 einen Schutz vor längeren Störimpulsen vom Eingangsanschluß 84 dar. Der dritte Schutzkondensator 32 dient außerdem als Stabilisationskondensator für die Versorgungsspannung des Komparators 4.

Für den Betrieb der Leuchtdiode 17 an der Ausgangsklemme 81 ist es zweckmäßig, den Effektivwert des durch sie fließenden Stroms konstant zu halten, um eine möglichst große Helligkeit zu erzielen, ohne die Leuchtdiode 17 zu beschädigen. Da die Leuchtdiode 17 einen nichtlinearen Widerstandsverlauf aufweist, ist dieser bei der Regelung der Ausgangsspannung $U_a$ entsprechend mit zu berücksichtigen. Durch entsprechende Dimensionierung der einzelnen Schaltungselemente kann die Schaltung jedoch ebenso so realisiert werden, daß die Bedingung eines konstanten Effektivwerts des über die Ausgangsklemme 81 fließenden Ausgangsstroms erfüllt wird.

Die Dioden 15, 16 dienen dem Schutz der Schaltung vor Verpolung. So wird ein an der Ausgangsklemme 81 liegendes Potential, welches höher ist als das Potential der Eingangsspannung $U_B$ über die zweite Diode 15 ausgeglichen und mittels der ersten Diode 16 ein zu hohes Potential am Ausgang des Komparators 4 und somit an der Basis 88 ausgeglichen. Zusätzlich dienen die Dioden 13, 14 als Verpolschutz für den Komparator 4. Der achte Widerstand 22 dient als Strombegrenzungswiderstand zum einen für den Elektrolytkondensator 36 und zum anderen für die Dioden 13, 14 im Falle einer Verpolung der Schaltung.

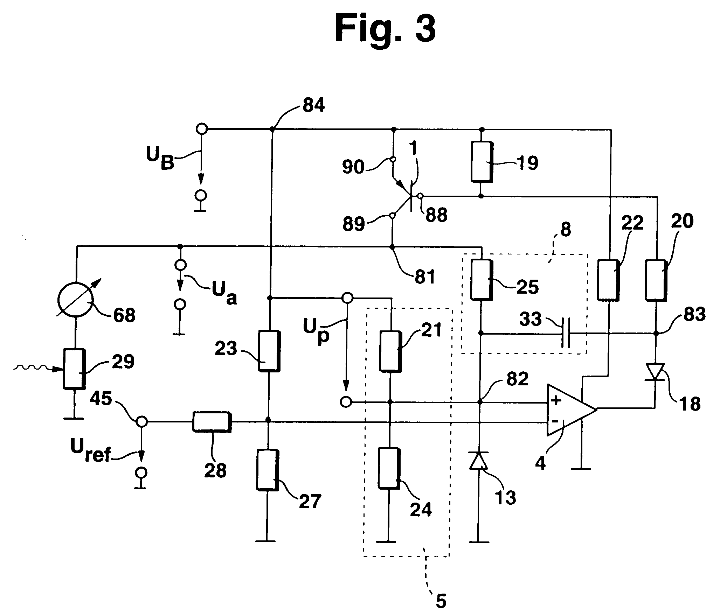

In der Figur 3 ist ein zweites Ausführungsbeispiel des elektronischen Spannungswandlers gezeigt, wobei die Bezeichnungen für gleiche Elemente aus den Figuren 1 und 2 beibehalten wurden. Die mit der Eingangsspannung $U_B$ belegte Eingangsklemme 84 ist wiederum mit dem Emitter 89 des Transistors 1, und über den ersten Widerstand 19 mit der Basis 8 des Transistors 1 verbunden. Weiter ist die Ausgangsklemme 81 über eine Serienschaltung aus einem Meßwerk 68 und einem sensitiven Widerstand 29 mit dem Massepotential verbunden. Das Meßwerk 68 weist einen niederohmigen Innenwiderstand auf. Parallel dazu ist die Ausgangsklemme 81 über den zweiten Widerstand 25 mit dem Summationspunkt 82 verbunden. Der nichtinvertierende Eingang des Komparators 4 ist sowohl über den Ladekondensator 33 mit dem Komparatorausgang 83, als auch direkt mit dem Summationspunkt 82 verbunden. Zwischen dem Massepotential und dem Summationspunkt 82 liegt außerdem der dritte Widerstand 24 und die dritte Diode 13, deren Anode mit dem Massepotential verbunden ist. Der Ausgang des Komparators 4 ist über eine Ausgangsdiode 18, deren Anode am Komparatorausgang 83 liegt, mit einem Schaltungspunkt verbunden, der im folgenden weiterhin als Komparatorausgang 83 bezeichnet wird, in Übereinstimmung mit Figur 2. Der Komparatorausgang 83 ist über den vierten Widerstand 20 mit der Basis 88 des Transistors 1 verbunden ist. Vom Summationspunkt 82 führt der fünfte Widerstand 21 zur Eingangsklemme 84, von der die Serienschaltung aus dem siebten Widerstand 23 und dem sechsten Widerstand 27 zum Massepotential führt. Der Abgriffspunkt zwischen den beiden Widerständen 23, 27 liegt am invertierenden Eingang des Komparators 4 und ist über einen zehnten Widerstand 28 mit einer Referenzeingangsklemme 45 verbunden, an der die Referenzspannung $U_{ref}$ anliegt. Die Spannungsversorgung des Komparators 4 erfolgt über den Anschluß des negativen Spannungsversorgungsanschlusses an das Massepotential und den Anschluß des positiven Spannungsversorgungsanschlusses über den achten Widerstand 22 an die Eingangsklemme 84. An der Ausgangsklemme 81 ist die Ausgangsspannung $U_a$ abgreifbar.

Die Funktionsweise dieser Schaltung unterscheidet sich nur in folgenden Punkten von der Funktionsweise der Schaltung aus Figur 2:

Für die Referenzspannung $U_{ref}$ steht hier eine externe Spannungsquelle zur Verfügung, wodurch keine Zener-Diode 12 nötig ist. Als Ergänzung entsteht zusätzlich eine Nachführung der am invertierenden Eingang des Komparators 4 anliegenden Spannung durch die Spannungsteilerschaltung aus den Widerständen 23, 27. Außerdem ist dieser Komparator 4 kein Open-collector-Komparator, sondern ein Operationsverstärker mit Gegentaktausgang. Daher ist dem Ausgang des Komparators 4 die Ausgangsdiode 18 nachgeschaltet. Das Umschalten des Ausgangs des Komparators 4 vom Massepotential auf das Potential der Eingangsspannung $U_B$ bewirkt dann ein Sperren der Ausgangsdiode 18, was dem hochohmigen Zustand des Open-collector-Komparators 4 aus Figur 2 entspricht. Ist das Meßwerk 68 hochohmig, so sollte ein Parallelwiderstand analog dem elften Widerstand 30 aus der Figur 2 angeordnet werden, um einen niederohmigen Pfad zum Massepotential zu gewährleisten.

Durch die sehr genaue Approximation der Leistungshyperbel mittels dieser Schaltung wird eine Ausgangsspannung $U_a$ erhalten, deren Effektivwert bei schwankender Eingangsspannung $U_B$ sehr konstant bleibt, wodurch ein sehr exaktes Zeigerverhalten des Meßwerks 68 erreicht wird. Insbesondere für die Anwendung bei einem effektivwertsensitiven Meßwerk, beispielsweise ein Bimetall- oder Hitzdrahtinstrument ist die Konstanthaltung des Effektivwerts der Ausgangsspannung von Bedeutung. Für eine zusätzliche Genauigkeitserhöhung sollte die Schaltung in dem Bereich betrieben werden, wo sich die Eingangsspannung $U_B$ deutlich oberhalb des Knickpunktes m aber auch deutlich unterhalb des Basispunktes n in der Figur 4c befindet. Dadurch wird das für die Schaltung nicht optimale Ladeverhalten des Ladekondensators 33 in einem relativ günstigen Bereich genutzt. Ein entsprechender Ausgleich läßt sich durch die korrekte Einstellung des Meßwerks 68 bei daran angeschlossenem elektronischen Spannungswandler erreichen.

Es ist ebenso vorgesehen, den Spannungswandler in umgekehrter Polarität zu betreiben. Dabei ist lediglich ein Vorzeichenwechsel der Eingangsspannung und gleichzeitig des Massepotentials vorzunehmen und die Polaritäten der Schaltungsbauteile zu vertauschen (Transistor 1, Dioden 13, 14, 15, 16, Elektrolytkondensator 36, invertierender und nichtinvertierender Eingang des Komparators 4 etc.). Die Potentiale der Eingangsspannung $U_B$ und des Massepotentials sind generell nicht auf bestimmte Wertebereiche festgelegt, sondern können jeden Potentialwert annehmen, sofern sie sich voneinander unterscheiden. Dies ist dann lediglich bei der Dimensionierung der Schaltung zu berücksichtigen. Insbesondere ist das Massepotential nicht ausschließlich gleich dem Potential 0 Volt zu sehen.

## Patentansprüche

1. Elektronischer Spannungswandler zur Erzeugung einer pulsförmigen Ausgangsspannung, mit einem elektronisch steuerbaren Schaltmittel, insbesondere einem Transistor, welches in Abhängigkeit vom Schaltzustand eines Schwellwertschalters eine elektrische Verbindung zwischen einem mit einer Eingangsspannung belegten Eingangsanschluß und einem Ausgangsanschluß, an dem die Ausgangsspannung abgreifbar ist, öffnet oder schließt, dadurch gekennzeichnet, daß der Ausgangsanschluß (81) über ein Tiefpaßfilter (7) mit einer vorgegebenen Zeitkon-stante ($\tau_1$) mit einem Summationspunkt (82) verbunden ist, der dem Schwellwertschalter (4) vorgeschaltet ist, dessen Schwellwertschalterausgang (83) über ein Hochpaßfilter (6) mit der gleichen vorgegebenen Zeitkonstante ($\tau_1$) mit dem Summationspunkt (82) verbunden ist, wobei der Schwellwertschalter (4) das Potential am Schwellwertschalterausgang (83) von einem ersten niedrigeren elektrischen Potential zu einem zweiten höheren elektrischen Potential dann umschaltet, wenn das Potential am Summationspunkt (82) höher ist, als das Potential einer dem Schwellwertschalter (4) zugeführten Referenzspannung ($U_{ref}$) und wobei das Schaltmittel (1) dann geschlossen wird, wenn das Potential am Schwellwertschalterausgang (83) vom zweiten höheren elektrischen Potential auf das erste niedrigere elektrische Potential schaltet.

2. Elektronischer Spannungswandler nach Anspruch 1, dadurch gekennzeichnet, daß zusätzlich die mittels eines Spannungsteilers (5) geteilte Eingangsspannung ($U_B$) an den Summationspunkt (82) geführt ist.

3. Elektronischer Spannungswandler nach Anspruch 1 oder 2, dadurch gekennzeichnet, daß zwischen dem Eingangsanschluß (84) und einem Bezugspotential eine Spannungsteilerschaltung mit wenigstens zwei Widerständen (23, 27) und einer dazu in Serie geschalteten Zener-Diode (12) vorgesehen ist und daß die Referenzspannung ($U_{ref}$) an der Spannungsteilerschaltung abgreifbar ist.

4. Elektronischer Spannungswandler nach einem der Ansprüche 1 bis 3, dadurch gekennzeichnet, daß am Summationspunkt (82) eine Diode (13) zur Begrenzung des Spannungsbereichs am Summationspunkt (82) zum Massepotential und eine weitere Diode (14) zur Begrenzung des Spannungsbereichs am Summationspunkt (82) zum Potential der Eingangsspannung ($U_B$) angeordnet ist.

5. Elektronischer Spannungswandler nach einem der Ansprüche 1 bis 4, dadurch gekennzeichnet, daß das Hochpaßfilter (6) und das Tiefpaßfilter (7) in einer Filterschaltung (8) zusammengefaßt sind, die sowohl als Hochpaßfilter (6) als auch als Tiefpaßfilter (7) wirkt, wobei die Wirkung jeweils vom Zustand der Potentiale in der Schaltung des elektronischen Spannungswandlers abhängt.

6. Elektronischer Spannungswandler nach Anspruch 5, dadurch gekennzeichnet, daß die Filterschaltung (8) wenigstens einen Widerstand (25), welcher zwischen dem Ausgangsanschluß (81) und dem Summationspunkt (82) angeordnet ist, und wenigstens einen Kondensator (33), der zwischen Summationspunkt (82) und dem Schwellwertschalterausgang (83) angeordnet ist, umfaßt.

7. Elektronischer Spannungswandler nach einem der Ansprüche 1 bis 6, dadurch gekennzeichnet, daß als Verpolschutz eine Schutzdiode (15) zwischen Eingangsanschluß (84) und Ausgangsanschluß (81) angeordnet ist.

8. Elektronischer Spannungswandler nach einem der Ansprüche 1 bis 7, dadurch gekennzeichnet, daß als EMV-Schutz ein erster Schutzkondensator (31) parallel zur Referenzspannung ($U_{ref}$) und/oder ein zweiter Schutzkondensator (34) parallel zur Eingangsspannung ($U_B$) und/oder ein dritter Schutzkondensator (32) zwischen dem positiven und dem negativen Versorgungsspannungsanschluß des Schwellwertschalters (4) vorgesehen sind.

9. Elektronischer Spannungswandler nach einem der Ansprüche 1 bis 8, dadurch gekennzeichnet, daß zwischen Kollektor (89) und Basis (88) des Transistors (1) ein EMV-Schutzkondensator (35) vorgesehen ist.

10. Elektronischer Spannungswandler nach einem der Ansprüche 1 bis 9, dadurch gekennzeichnet, daß zwischen dem Ausgangsanschluß (81) und dem Bezugspotential eine Leuchtdiode (17) in Serie mit einem Widerstand (26) und einem Schalter (43) geschaltet ist.

# Fig. 1

- 84
- $U_B$
- 1
- 81
- $U_a$
- 83
- 6
- 8
- HP, $\tau_1$
- TP, $\tau_1$
- a
- 5
- 7
- 82
- $U_{ref}$
- 4

**Fig. 2**

EP 0 690 552 A2

# Fig. 3

EP 0 690 552 A2

Fig. 4a

Fig. 4b

Fig. 4c

# Fig. 5a

# Fig. 5b

# Fig. 5c

# Fig. 6

# Fig. 7a

# Fig. 7b

# Fig. 7c